# EUROPÄISCHE PATENTSCHRIFT

(11) **EP 4 374 463 B1**
(45) Veröffentlichungstag und Bekanntmachung des Hinweises auf die Patenterteilung: **16.09.2026**
(21) Anmeldenummer: 22751273.8
(22) Anmeldetag: 08.07.2022
(51) Int. Cl.: H01R 12/52, H01R 12/58, H01R 12/70, H01R 12/91, H05K 1/14

(54) **LEITERKARTENANORDNUNG**
PRINTED CIRCUIT BOARD ASSEMBLY
ENSEMBLE CARTE DE CIRCUIT IMPRIMÉ

(30) Priorität: 23.07.2021 DE 102021119087
(43) Veröffentlichungstag der Anmeldung: 29.05.2024
(73) Patentinhaber: HARTING Electronics GmbH, 32339 Espelkamp (DE)
(72) Erfinder: GENAU, Marc, 32339 Espelkamp (DE); BUSSMANN, Rainer, 32339 Espelkamp (DE)
(86) Internationale Anmeldenummer: PCT/DE2022/100490
(87) Internationale Veröffentlichungsnummer: WO 2023/001330

(56) Entgegenhaltungen:
- EP-B1- 3 399 597
- DE-A1- 102018 105 784
- DE-A1- 102020 211 008
- DE-B4- 112012 002 122
- US-A1- 2014 087 592

## Beschreibung

Die Erfindung geht aus von einer Leiterkartenanordnung nach der Gattung des unabhängigen Anspruchs 1.

Derartige Leiterkartenanordnungen sind oft in Gehäusen von elektrischen Geräten, Steuereinheiten oder ähnlichen Systemen verbaut.

### Stand der Technik

Die oben erwähnten Gehäuse sind, insbesondere im industriellen Umfeld, starken Vibrationen ausgesetzt, wodurch insbesondere die Steckverbindungen der implementierten Leiterkarten leiden und ausfallen können.

Die EP 3 794 684 A1 zeigt ein Leiterkartenkontaktelement, dessen Kontaktsteckung in der Leiterkarte ein gewisses Spiel aufweist, wodurch bestimmte Vibrationsbelastungen ausgeglichen werden können. Mit einem solchen Kontaktelement können zwei Leiterkarten mit einem Kabel miteinander kontaktiert werden. Hierbei ist auf eine geeignete Kabelführung zu achten.

WO 2021/013297 A1 zeigt ein Leiterkartenkontaktelement zum Kontaktieren von zwei Leiterkarten. Mit dem Anschlussende wird das Kontaktelement fest auf einer ersten Leiterkarte befestigt. Mit dem anderen Ende durchdringt es eine Kontaktöffnung einer zweiten Leiterkarte. Durch eine spezielle Geometrie verklemmt sich das zweite Ende in dieser Kontaktöffnung. Hierdurch wird ein Vibrationsspielraum erzeugt. Allerdings verschleißt der elektrische Kontakt zwischen dem Kontaktelement und der Kontaktöffnung bei einer kontinuierlich anhaltenden Vibrationsbelastung mit der Zeit.

Die EP 3 399 597 B1 zeigt ein Verfahren zum toleranzausgleichenden Zusammenschalten erster und zweiter Leiterplatten mithilfe eines schwimmenden Verbinders. Der schwimmende Verbinder weist dazu federgelagerte Kontaktelemente auf.

Die DE 11 2012 002 122 B4 zeigt einen Steckkörper zur elektrischen Kontaktierung einer Leiterkarte. Die Kontaktelemente des Steckkörpers weisen zum Toleranzausgleich einen halbkreisförmigen Biegebereich auf. Die US 2014/0087592 A1 zeigt einen Steckverbinder zur Kontaktierung zweier Leiterkarten. Der Steckverbinder weist an seinen Schmalseiten Rastarme auf, mit denen er jeweils auf den gegenüberliegenden Leiterkarten verrastbar ist.

Die DE 10 2020 211 008 A1 zeigt einen Stromrichter für ein Elektrofahrzeug. Der Stromrichter weist erste Leiterplatte und eine zweite Leiterplatte auf, die über einen Kunststoffträger mit elastischen Kontaktelementen miteinander verbunden sind.

Das Deutsche Patent- und Markenamt hat in der Prioritätsanmeldung zur vorliegenden Anmeldung den folgenden Stand der Technik recherchiert: US 2011/0104911 A1, DE 10 2015 105 784 A1, DE 11 2012 002 122 B4, EP 3 794 684 A1 und WO 2021/013297 A1.

### Aufgabenstellung

Die Aufgabe der Erfindung besteht darin eine zuverlässige Leiterkartenanordnung vorzuschlagen.

Die Aufgabe wird durch den Gegenstand des unabhängigen Anspruchs gelöst.

Vorteilhafte Ausgestaltungen der Erfindung sind in den Unteransprüchen und der folgenden Beschreibung angegeben.

Die erfindungsgemäße Leiterkartenanordnung umfasst eine erste Leiterkarte. Die erste Leiterkarte weist zumindest zwei Kontaktöffnungen für Leiterkartenkontaktelemente auf. Die Leiterkartenanordnung umfasst zumindest zwei solcher Leiterkartenkontaktelemente. Die Leiterkartenkontaktelemente weisen jeweils ein Steckende und ein Anschlussende auf, wobei das Steckende jeweils in eine Kontaktöffnung der ersten Leiterkarte eingesteckt ist.

Die Leiterkartenanordnung weist eine zweite Leiterkarte (3) auf. Die zweite Leiterkarte weist wiederum zumindest zwei Kontaktöffnungen auf. Die Kontaktöffnungen der ersten und zweiten Leiterkarte können geometrisch gleich ausgestaltet sein. Vorzugsweise sind die Kontaktöffnungen jeweils aus einer im Wesentlichen kreisrunden Durchgangsöffnung mit einem Randbereich, der elektrisch leitendes Material aufweist oder daraus besteht, gebildet ist. Der Randbereich kann wiederum mit einer Leiterbahn der jeweiligen Leiterkarte elektrisch leitend verbunden sein. Vorteilhafterweise weist das Steckende des Leiterkartensteckverbinders axiale Schlitze auf. Hierdurch wird eine gewisse Klemmwirkung des Kontaktendes des Leiterkartenkontaktelements in der Kontaktöffnung erzeugt.

Das Anschlussende der Leiterkartenkontaktelemente ist jeweils an einer Kontaktöffnung der zweiten Leiterkarte befestigt. Erfindungsgemäß wird hierfür eine Schraubbefestigung bzw. Schraubverbindung gewählt.

Die Leiterkartenanordnung umfasst weiterhin ein Kunststoffgehäuse. Das Kunststoffgehäuse ist auf der ersten Leiterkarte montiert bzw. darauf befestigt. Im Kunststoffgehäuse sind die Leiterkartenkontaktelemente verschiebbar gelagert.

Vorzugsweise sind die erste und die zweite Leiterkarte parallel zueinander angeordnet. Eine solche Anordnung ist beispielsweise in elektrischen Geräten zu finden, wobei die erste Leiterkarte an einer ersten Geräteinnenwand und die zweite Leiterkarte an einer gegenüberliegenden, zweiten Geräteinnenwand angeordnet ist. Über entsprechende Gerätebuchsen an den Gerätewänden können die Leiterkarten dann von außen über einen Steckverbinder kontaktiert werden. Dadurch können elektrische Ströme und/oder Daten auf das Gerät übertragen werden.

Vorzugsweise ist die Verschieberichtung der Leiterkartenkontaktelemente im Kunststoffgehäuse parallel zum Normalenvektor der Leiterplattenebene der Leiterkarten ausgerichtet. Dadurch ist insgesamt die zweite Leiterkarte relativ zur ersten Leiterkarte und parallel dazu verschiebbar. Betrachtet man die Leiterkartenanordnung als Ganzes, sind durch die oben aufgeführten technischen Mittel die erste und zweite Leiterkarte relativ zueinander beweglich abgeordnet. Dabei bewegt sich die zweite Leiterkarte parallel zur ersten Leiterkarte hin oder von dieser weg.

Die Relativbeweglichkeit der Leiterkarten zueinander wird auch als Leiterkartenspiel bezeichnet. Hierdurch wird eine Vibrationsbelastung von technischen Geräten mit einer solchen Leiterkartenanordnung verringert und die Langlebigkeit solcher technischen Geräte erheblich erhöht. Weiterhin können durch das Leiterkartenspiel auch bauliche Toleranzen ausgeglichen werden. Dadurch wird die Zusammenarbeit derartiger Gerätehersteller mit Zulieferern erleichtert.

Vorzugsweise sind die Leiterkartenkontaktelemente verdrehsicher im Kunststoffgehäuse gelagert und darin auch verliersicher gehalten.

Dadurch kann man diese durch die Leiterkarte hindurch mit Schrauben verbinden, ohne das Kontaktelement noch einmal händisch am Verdrehen hindern zu müssen.

In einer vorteilhaften Ausgestaltung der Erfindung sind am Kunststoffgehäuse seitlich abstehende Ösen angeformt. Die erste Leiterkarte weist hierzu korrelierende Schrauböffnungen auf. Darüber kann das Kunststoffgehäuse auf der ersten Leiterkarte verschraubt werden. Ferner weist das Kunststoffgehäuse Dorne auf, die in dafür vorgesehene Öffnungen der ersten Leiterkarte einsteckbar sind. Hierdurch wird insbesondere eine stabile Vorfixierung des Kunststoffgehäuses auf der Leiterkarte für eine anschließende Verschraubung erzeugt. Die Dorne haben jeweils vorzugsweise einen kreuzförmigen Querschnitt.

### Ausführungsbeispiel

Ein Ausführungsbeispiel der Erfindung ist in den Zeichnungen dargestellt und wird im Folgenden näher erläutert. Es zeigen:
- Fig. 1: eine perspektivische Darstellung einer erfindungsgemäßen Leiterkartenanordnung,
- Fig. 2: eine Explosionsdarstellung der erfindungsgemäßen Leiterkartenanordnung,
- Fig. 3: Eine Draufsicht auf ein Kunststoffgehäuse der erfindungsgemäßen Leiterkartenanordnung,
- Fig. 4: eine geschnittene Seitenansicht der Leiterkartenanordnung in einer ersten Spielstellung und
- Fig. 5: eine geschnittene Seitenansicht der Leiterkartenanordnung in einer zweiten Spielstellung.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

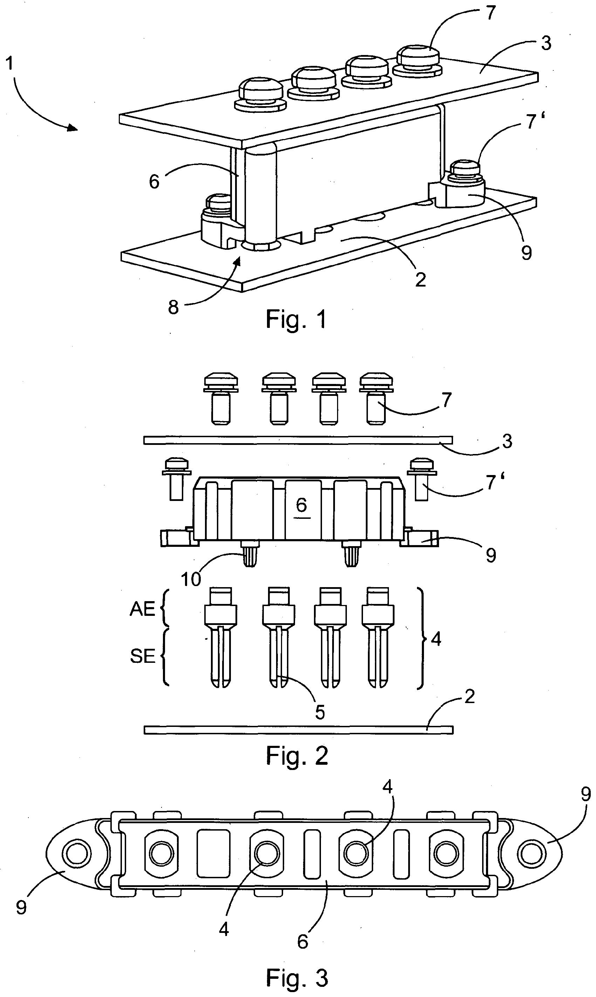

Die Figur 1 zeigt eine perspektivische Darstellung einer erfindungsgemäßen Leiterkartenanordnung 1. In Figur 2 ist eine entsprechende Explosionsdarstellung der Leiterkartenanordnung 1 in einer Seitenansicht gezeigt.

Die Leiterkartenanordnung weist eine erste Leiterkarte 2 und eine dazu parallel angeordnete zweite Leiterkarte 3 auf. Auf der ersten Leiterkarte ist ein Kunststoffgehäuse 6 montiert und verliersicher befestigt. Dazu weist das Kunststoffgehäuse 6 Dorne 10 mit einem kreuzförmigen Querschnitt auf, welche in entsprechende Öffnungen der ersten Leiterkarte 2 eingesteckt sind. Weiterhin sind am Kunststoffgehäuse 6 seitlich Ösen angeformt, in welche Schrauben 7' eintauchen und in dafür vorgesehene Schrauböffnungen der ersten Leiterkarte 2 verschraubt sind.

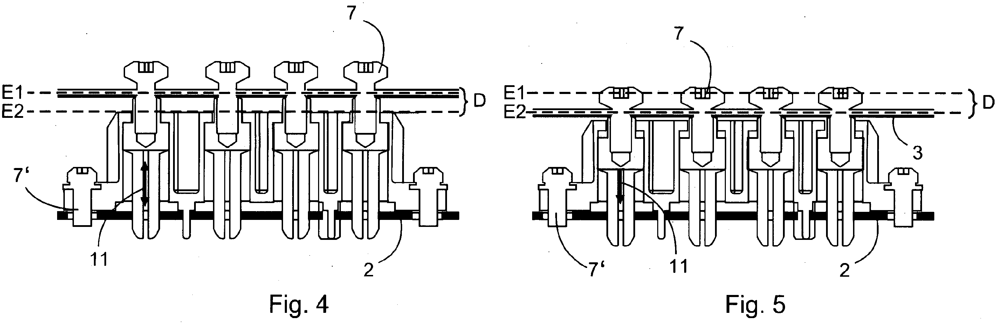

In dem Kunststoffgehäuse 6 sind die Leiterkartenkontaktelemente 4 derart gelagert, dass sie eine Verschieberichtung aufweisen, die in Richtung des Doppelpfeils 11 (siehe Figuren 4 und 5) ausgerichtet ist. Die Leiterkartenkontaktelemente 4 sind jedoch nicht radial entlang dieser Bewegungsachse drehbar.

Wie in Figur 2 zu sehen ist, weisen die Leiterkartenkontaktelemente 4 jeweils ein Steckende SE und ein Anschlussende AE auf. Mit dem Steckende SE werden die Leiterkartenkontaktelemente 4 in eine Kontaktöffnung 8 der ersten Leiterkarte 2 eingesteckt. Mit dem Anschlussende werde die Leiterkartenkontaktelemente 4 an einer entsprechenden Kontaktöffnung (aus darstellerischen Gründen nicht gezeigt) der zweiten Leiterkarte 3 mithilfe von Schrauben 7 verschraubt.

In Figur 4 ist die maximal entfernte Position zwischen erster Leiterkarte 2 und zweiter Leiterkarte 3 dargestellt. Die Figur 5 zeigt hingegen die maximal nahe Position zwischen den Leiterkarten 2, 3. Dabei sind die unterschiedlichen Positionsebenen E1, E2 der zweiten Leiterkarte 3 eingezeichnet. Der Höhenunterschied dieser Ebenen ist in den Figuren mit dem Großbuchstaben "D" gekennzeichnet. Der Höhenunterschied D kann auch als Spiel bzw. Bewegungsspielraum bezeichnet werden.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutierten Kombinationen nicht die einzig möglichen sind. Insbesondere können einander entsprechende Einheiten oder Merkmalskomplexe aus unterschiedlichen Ausführungsbeispielen miteinander ausgetauscht werden.

### Bezugszeichenliste

- 1: Leiterkartenanordnung
- 2: Erste Leiterkarte
- 3: Zweite Leiterkarte
- 4: Leiterkartenkontaktelement
- 5: Schlitz
- 6: Kunststoffgehäuse
- 7: Schraube
- 8: Kontaktöffnung
- 9: Befestigungsöse des Kunststoffgehäuses 6
- 10: Dorn des Kunststoffgehäuses 6
- 11: Doppelpfeil
- SE: Steckende des Leiterkartenkontaktelements 4
- AE: Anschlussende des Leiterkartenkontaktelements 4
- E: Ebene
- D: Höhenunterschied / Spiel

## Patentansprüche

1. Leiterkartenanordnung (1), aufweisend
- eine erste Leiterkarte (2) mit zumindest zwei Kontaktöffnungen (8),
- zumindest zwei Leiterkartenkontaktelemente (4) mit jeweils einem Steckende (SE) und einem Anschlussende (AE), wobei das Steckende (SE) jeweils in eine Kontaktöffnung (8) der ersten Leiterkarte (2) eingesteckt ist,
- eine zweite Leiterkarte (3) mit zumindest zwei Kontaktöffnungen
- und ein Kunststoffgehäuse (6), welches auf der ersten Leiterkarte (2) montiert ist und in welchem die Leiterkartenkontaktelemente (4) verschiebbar gelagert sind, **dadurch gekennzeichnet, dass** das Anschlussende (AE) der Leiterkartenkontaktelemente (4) jeweils an einer Kontaktöffnung der zweiten Leiterkarte (3) verschraubt ist.

2. Leiterkartenanordnung (1) nach Anspruch 1
**dadurch gekennzeichnet, dass**
die erste und die zweite Leiterkarte (2, 3) parallel zueinander angeordnet sind.

3. Leiterkartenanordnung (1) nach einem der vorstehenden Ansprüche **dadurch gekennzeichnet, dass** die Verschieberichtung (11) der Leiterkartenkontaktelemente (4) im Kunststoffgehäuse (6) parallel zum Normalenvektor der Leiterplattenebene der Leiterkarten (2, 3) ausgerichtet ist.

4. Leiterkartenanordnung (1) nach einem der vorstehenden Ansprüche **dadurch gekennzeichnet, dass**
die Kontaktöffnung (8) aus einer im Wesentlichen kreisrunden Durchgangsöffnung mit einem Randbereich gebildet ist, wobei der Randbereich ein elektrisch leitendes Material aufweist, oder daraus besteht.

5. Leiterkartenanordnung (1) nach einem der vorstehenden Ansprüche **dadurch gekennzeichnet, dass**
die Leiterkartenkontaktelemente (4) verdrehsicher im Kunststoffgehäuse (6) gelagert sind.

6. Leiterkartenanordnung (1) nach einem der vorstehenden Ansprüche **dadurch gekennzeichnet, dass**
am Kunststoffgehäuse (6) seitlich abstehende Befestigungsösen (9) angeformt sind und die erste Leiterkarte (2) hierzu korrelierende Schrauböffnungen aufweist, so dass das Kunststoffgehäuse (6) auf der ersten Leiterkarte (2) festschraubbar ist.

7. Leiterkartenanordnung (1) nach einem der vorstehenden Ansprüche **dadurch gekennzeichnet, dass**
das Kunststoffgehäuse (6) Dorne (10) aufweist, die in dafür vorgesehene Öffnungen der ersten Leiterkarte (2) einsteckbar sind.

8. Leiterkartenanordnung (1) nach vorstehendem Anspruch **dadurch gekennzeichnet, dass**
die Dorne (10) jeweils einen kreuzförmigen Querschnitt aufweisen.

9. Leiterkartenanordnung (1) nach einem der vorstehenden Ansprüche **dadurch gekennzeichnet, dass**
das Steckende (SE) des Leiterkartensteckverbinders (4) zumindest zwei axiale Schlitze (5) aufweist.

10. Leiterkartenanordnung (1) nach einem der vorstehenden Ansprüche
**dadurch gekennzeichnet, dass**
die zweite Leiterkarte (3) relativ zur ersten Leiterkarte (2) und parallel dazu verschiebbar ist.

## Claims

1. Circuit board arrangement (1), comprising
- a first circuit board (2) with at least two contact openings (8),
- at least two circuit board contact elements (4) each having a plug end (SE) and a connection end (AE), wherein the plug end (SE) is respectively inserted into a contact opening (8) of the first circuit board (2),
- a second circuit board (3) with at least two contact openings, and
- a plastic housing (6) which is mounted on the first circuit board (2) and in which the circuit board contact elements (4) are displaceably supported,
**characterized in that** the connection end (AE) of the circuit board contact elements (4) is respectively screwed to a contact opening of the second circuit board (3).

2. Circuit board arrangement (1) according to claim 1, **characterized in that** the first and the second circuit board (2, 3) are arranged parallel to each other.

3. Circuit board arrangement (1) according to one of the preceding claims, **characterized in that** the displacement direction (11) of the circuit board contact elements (4) in the plastic housing (6) is aligned parallel to the normal vector of the circuit board plane of the circuit boards (2, 3).

4. Circuit board arrangement (1) according to one of the preceding claims, **characterized in that** the contact opening (8) is formed from a substantially circular through opening with an edge region, wherein the edge region comprises or consists of an electrically conductive material.

5. Circuit board arrangement (1) according to one of the preceding claims, **characterized in that** the circuit board contact elements (4) are supported in a rotation-proof manner in the plastic housing (6).

6. Circuit board arrangement (1) according to one of the preceding claims, **characterized in that** laterally protruding fastening eyelets (9) are molded on the plastic housing (6) and the first circuit board (2) has screw openings correlating therewith, so that the plastic housing (6) can be screwed onto the first circuit board (2).

7. Circuit board arrangement (1) according to one of the preceding claims, **characterized in that** the plastic housing (6) has pins (10) which can be inserted into openings provided therefor in the first circuit board (2).

8. Circuit board arrangement (1) according to the preceding claim, **characterized in that** the pins (10) each have a cross-shaped cross-section.

9. Circuit board arrangement (1) according to one of the preceding claims, **characterized in that** the plug end (SE) of the circuit board connector (4) has at least two axial slots (5).

10. Circuit board arrangement (1) according to one of the preceding claims, **characterized in that** the second circuit board (3) is displaceable relative to and parallel to the first circuit board (2).

## Revendications

1. Agencement de cartes de circuit imprimé (1), comprenant
- une première carte de circuit imprimé (2) avec au moins deux ouvertures de contact (8),
- au moins deux éléments de contact de carte de circuit imprimé (4) ayant chacun une extrémité d'enfichage (SE) et une extrémité de raccordement (AE), l'extrémité d'enfichage (SE) étant respectivement insérée dans une ouverture de contact (8) de la première carte de circuit imprimé (2),
- une deuxième carte de circuit imprimé (3) avec au moins deux ouvertures de contact, et
- un boîtier en plastique (6), qui est monté sur la première carte de circuit imprimé (2) et dans lequel les éléments de contact de carte de circuit imprimé (4) sont supportés de manière déplaçable,
**caractérisé en ce que** l'extrémité de raccordement (AE) des éléments de contact de carte de circuit imprimé (4) est respectivement vissée à une ouverture de contact de la deuxième carte de circuit imprimé (3).

2. Agencement de cartes de circuit imprimé (1) selon la revendication 1, **caractérisé en ce que** la première et la deuxième carte de circuit imprimé (2, 3) sont disposées parallèlement l'une à l'autre.

3. Agencement de cartes de circuit imprimé (1) selon l'une des revendications précédentes, **caractérisé en ce que** la direction de déplacement (11) des éléments de contact de carte de circuit imprimé (4) dans le boîtier en plastique (6) est alignée parallèlement au vecteur normal du plan de carte de circuit imprimé des cartes de circuit imprimé (2, 3).

4. Agencement de cartes de circuit imprimé (1) selon l'une des revendications précédentes, **caractérisé en ce que** l'ouverture de contact (8) est formée d'une ouverture traversante essentiellement circulaire avec une zone de bord, la zone de bord comprenant ou étant constituée d'un matériau électriquement conducteur.

5. Agencement de cartes de circuit imprimé (1) selon l'une des revendications précédentes, **caractérisé en ce que** les éléments de contact de carte de circuit imprimé (4) sont supportés de manière anti-rotation dans le boîtier en plastique (6).

6. Agencement de cartes de circuit imprimé (1) selon l'une des revendications précédentes, **caractérisé en ce que** des œillets de fixation (9) faisant saillie latéralement sont moulés sur le boîtier en plastique (6) et la première carte de circuit imprimé (2) présente des ouvertures de vissage correspondantes, de sorte que le boîtier en plastique (6) peut être vissé sur la première carte de circuit imprimé (2).

7. Agencement de cartes de circuit imprimé (1) selon l'une des revendications précédentes, **caractérisé en ce que** le boîtier en plastique (6) présente des broches (10) qui peuvent être insérées dans des ouvertures prévues à cet effet dans la première carte de circuit imprimé (2).

8. Agencement de cartes de circuit imprimé (1) selon la revendication précédente, **caractérisé en ce que** les broches (10) présentent chacune une section transversale en forme de croix.

9. Agencement de cartes de circuit imprimé (1) selon l'une des revendications précédentes, **caractérisé en ce que** l'extrémité d'enfichage (SE) du connecteur de carte de circuit imprimé (4) présente au moins deux fentes axiales (5).

10. Agencement de cartes de circuit imprimé (1) selon l'une des revendications précédentes, **caractérisé en ce que** la deuxième carte de circuit imprimé (3) est déplaçable par rapport à la première carte de circuit imprimé (2) et parallèlement à celle-ci.
